# EUROPEAN PATENT APPLICATION

(11) **EP 4 339 954 A1**
(43) Date of publication of application: **20.03.2024**
(21) Application number: 23189483.3
(22) Date of filing: 03.08.2023
(51) Int. Cl.: G11C 16/04, G11C 16/34

(54) **STORAGE DEVICE INCLUDING FLASH MEMORY AND BLOCK CONTINUOUS-WRITE OPERATION METHOD THEREOF**

(30) Priority: 13.09.2022 KR 20220114876
(71) Applicant: Samsung Electronics Co., Ltd., Suwon-si, Gyeonggi-do 16677 (KR)
(72) Inventor: KO, Kuihan, 16677 Suwon-si, Gyeonggi-do (KR); PARK, Sang-Won, 16677 Suwon-si, Gyeonggi-do (KR)
(74) Representative: Kuhnen & Wacker Patent- und Rechtsanwaltsbüro PartG mbB

(57) **Abstract**

Disclosed is a storage device which includes a first word line (WL6 - WL8) connected with memory cells (MC6 - MC8) being in a program state, a second word line (WL1 - WL3) connected with memory cells (MC1 - MC3) being in an erase state, and a free word line (WL5, WL4) between the first and second word lines (WL1 - WL3, WL6 - WL8) and connected with memory cells (MC5, MC4) being in the erase state. Whether a block continuous-write is possible with respect to the memory cells (MC1 - MC3) connected with the second word line (WL1 - WL3) is determined by verifying the erase state of the memory cells (MC5, MC4) connected with the free word (WL5, WL4) line during one busy signal period. According to the present disclosure, because whether a block continuous-write is possible is determined with respect to a plurality of free pages during one busy signal period, a time taken to perform the block continuous-write operation may decrease.

## Description

### BACKGROUND

Example embodiments of the present disclosure described herein relate to a semiconductor memory device, and more particularly, relate to a storage device including a flash memory and a block continuous-write operation method thereof.

A semiconductor memory may be mainly classified as a volatile memory or a non-volatile memory. A read or write speed of the volatile memory (e.g., a DRAM or an SRAM) is fast, but data stored in the volatile memory disappear when a power supply is turned off. In contrast, the nonvolatile memory may retain data even when the power supply is interrupted.

A representative example of the non-volatile memory is a flash memory. The flash memory may store multi-bit data of two or more bits in one memory cell. The flash memory that stores the multi-bit data may have one erase state and a plurality of program states depending on threshold voltage distributions. In the flash memory, it may be advantageous to secure a read margin between program states.

However, as the number of data bits stored in one memory cell increases, the read margin of the flash memory becomes narrower. Also, when a threshold voltage of a memory cell changes due to various reasons, the flash memory may fail to secure a sufficient read margin. For example, when the pass voltage disturbance or the program voltage disturbance occurs in the flash memory, a threshold voltage of a memory cell may increase. When the threshold voltage of the memory cell increases, the erase state and the program state may overlap each other. As a result, a read fail may occur during a read operation.

Programmed pages and non-programmed pages may be present in one memory block of the flash memory. The flash memory may perform a block continuous-write operation with respect to the non-programmed page(s).

To perform the block continuous-write operation, a conventional flash memory may determine whether the block continuous-write is possible, with respect to all non-programmed pages. Also, the conventional flash memory may perform the read operation and the data output operation for each page; to this end, the conventional flash memory may require as many command invocations as the number of pages. This means that the conventional flash memory may require extra time to perform a block continuous-write operation.

### SUMMARY

Example embodiments of the present disclosure provide a flash memory capable of reducing a time taken to perform a block continuous-write operation by performing the block continuous-write operation with respect to some of non-programmed pages and a storage device including the same.

Example embodiments of the present disclosure provide a flash memory capable of reducing a time taken to perform a block continuous-write operation by determining whether the block continuous-write for a plurality of pages is possible, by using one command invocation and a storage device including the same.

According to example embodiments, a storage device may include a first word line connected with memory cells being in a program state, a second word line connected with memory cells being in an erase state, and a free word line between the first and second word lines and connected with memory cells being the erase state. Whether a block continuous-write is possible with respect to the memory cells connected with the second word line may be determined by verifying the erase state of the memory cells connected with the free word line during one busy signal period.

According to example embodiments, a flash memory may include a first word line that is connected with memory cells being in a program state, a second word line that is connected with memory cells being in an erase state, and a free word line between the first and second word lines and is connected with memory cells being the erase state. The free word line may be divided into a plurality of free pages by a plurality of string selection lines, and the plurality of string selection lines may be sequentially activated during one busy signal period such that erase states of the plurality of free pages are sequentially verified.

According to example embodiments, a block continuous-write operation method may include verifying whether memory cells connected with a free word line are in an erase state, during one busy signal period, and determining whether a block continuous-write of the memory cells connected with a second word line is possible, depending on a result of the verifying.

### BRIEF DESCRIPTION OF THE FIGURES

The above and other objects and features of the present disclosure will become apparent by describing in detail example embodiments thereof with reference to the accompanying drawings.
FIG. 1 is a block diagram illustrating a storage device according to example embodiments of the present disclosure.
FIG. 2 is a block diagram illustrating a flash memory illustrated in FIG. 1.
FIG. 3 is a circuit diagram illustrating a memory block of a memory cell array of FIG. 2.
FIG. 4 is a circuit diagram illustrating cell strings selected by an eighth string selection line from among cell strings of a memory block illustrated in FIG. 3.
FIG. 5 is a circuit diagram illustrating cell strings connected with a first bit line and a common source line from among cell strings of a memory block illustrated in FIG. 3.
FIG. 6 is a diagram illustrating threshold voltage distributions of memory cells illustrating in FIG. 3.
FIG. 7 is a circuit diagram illustrating a first page buffer illustrated in FIG. 2.
FIG. 8 is a flowchart for describing a block continuous-write operation of a storage device illustrated in FIG. 1.
FIG. 9 is a diagram illustrating a method in which a free word line checker illustrated in FIG. 1 checks whether to continue to do a block continuous-write by using one word line.
FIG. 10 is a timing diagram illustrating a method for checking whether to continue to do a block continuous-write of the diagram illustrated in FIG. 9.
FIG. 11 is a diagram illustrating a method in which a free word line checker illustrated in FIG. 1 checks whether to continue to do a block continuous-write by using two word lines.
FIG. 12 is a timing diagram illustrating a method for checking whether to continue to do a block continuous-write of the diagram illustrated in FIG. 11.
FIG. 13 is a block diagram illustrating a storage device according to other example embodiments of the present disclosure.
FIG. 14 is a block diagram illustrating a flash memory illustrated in FIG. 13.
FIG. 15 is a timing diagram illustrating a method for checking whether to continue to do a block continuous-write of a flash memory illustrated in FIG. 14.
FIG. 16 is a flowchart for describing a block continuous-write operation of a flash memory illustrated in FIG. 14.
FIG. 17 is a block diagram illustrating an off cell counter illustrated in FIG. 14.
FIG. 18 is a block diagram illustrating an example in which a storage device according to example embodiments of the present disclosure is implemented with a solid state drive.

### DETAILED DESCRIPTION

Below, example embodiments of the present disclosure will be described in detail and clearly to such an extent that an ordinary one in the art easily implements the inventive concepts.

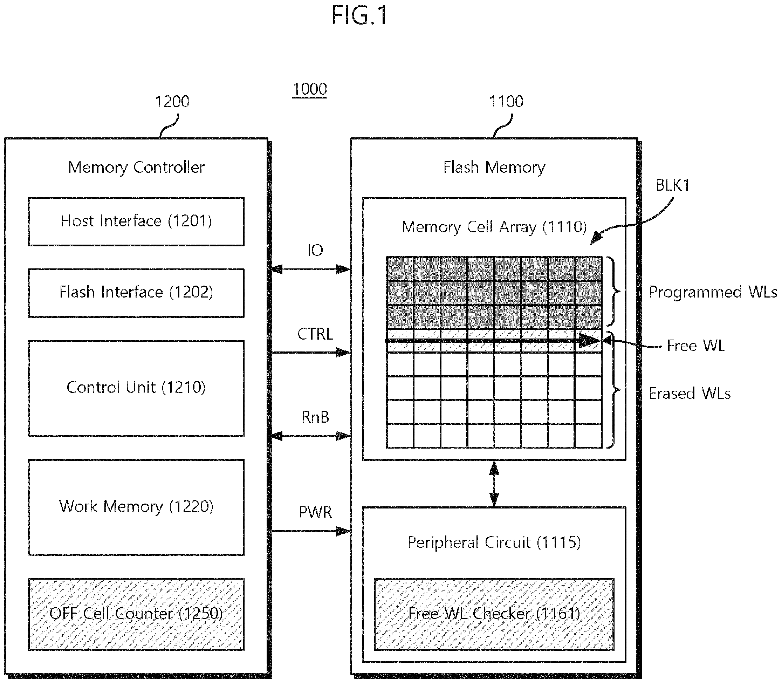

FIG. 1 is a block diagram illustrating a storage device according to example embodiments of the present disclosure. Referring to FIG. 1, a storage device 1000 may include a flash memory 1100 and/or a memory controller 1200. The flash memory 1100 and the memory controller 1200 may be connected through a data input/output line IO, a control line CTRL, and/or a power line PWR.

The flash memory 1100 may perform a write, read, or erase operation in response to signals received from the memory controller 1200. The flash memory 1100 may send a ready/busy signal RnB to the memory controller 1200. When the flash memory 1100 performs the read, write, or erase operation internally, the flash memory 1100 may set the ready/busy signal RnB to a busy state (e.g., logic low). When the flash memory 1100 completes the read, write, or erase operation internally, the flash memory may set the ready/busy signal RnB to a ready state (e.g., logic high).

The flash memory 1100 includes a memory cell array 1110 and/or a peripheral circuit 1115. The memory cell array 1110 may be placed next to the peripheral circuit 1115 or on/over the peripheral circuit 1115 depending on a design/layout structure. A structure in which the memory cell array 1110 is placed on the peripheral circuit 1115 is called a cell on peripheral (COP) structure. The memory cell array 1110 may be implemented with a chip that is independent of the peripheral circuit 1115. An upper chip including the memory cell array 1110 and a lower chip including the peripheral circuit 1115 may be coupled to each other by a bonding scheme. This structure is called a chip to chip (C2C) structure.

The memory cell array 1110 may include a plurality of memory blocks. One memory block BLK1 is illustrated in FIG. 1. The memory block BLK1 may include programmed word lines and erased word lines. The programmed word line refers to a word line where the program operation is performed. The erased word line refers to a word line where the program operation is not yet performed.

The erased word lines may be programmed through the block continuous-write operation. Herein, the block continuous-write operation refers to an operation of performing the program operation for the erased word line to be continuous to the programmed word line. A free word line refers to a word line, which is used to determine whether the block continuous-write is possible, from among the erased word lines. The free word line may include one word line or two or more word lines. An example in which the free word line includes one word line is illustrated in FIG. 1.

The peripheral circuit 1115 may include analog circuits, digital circuits, or the analog and digital circuits, which are necessary to store data in the memory cell array 1110 or to read data stored in the memory cell array 1110. The peripheral circuit 1115 may be supplied with an external power PWR from the memory controller 1200 and may generate internal powers of various levels.

The peripheral circuit 1115 may receive a command, an address, and/or data from the memory controller 1200 through the data input/output line IO. The peripheral circuit 1115 may store data in the memory cell array 1110 in response to a control signal CTRL. Also, the peripheral circuit 1115 may read data stored in the memory cell array 1110 and may provide the read data to the memory controller 1200.

The peripheral circuit 1115 may include a free word line checker 1161. The free word line checker 1161 may check, in real time, whether the block continuous-write is possible, by using the free word line. For example, the free word line checker 1161 may check whether the block continuous-write is possible, by verifying the erase state of memory cells connected with the free word line. The free word line checker 1161 may verify whether the memory cells connected with the free word line are off cells. Herein, the off cell refers to a memory cell whose threshold voltage is greater than an erase verify voltage. The free word line checker 1161 may provide off cell information to the memory controller 1200.

The memory controller 1200 may include a host interface 1201, a flash interface 1202, a control unit 1210, a work memory 1220, and/or an off cell counter 1250. Although not illustrated in FIG. 1, the memory controller 1200 may further include various components. For example, the memory controller 1200 may further include a buffer memory that temporarily stores data associated with the read or write operation of the flash memory 1100.

The host interface 1201 provides an interface between the host and the memory controller 1200. The host interface may be configured to comply with various interface schemes such as ATA (Advanced Technology Attachment), SATA (Serial ATA), e-SATA (external SATA), SCSI (Small Computer Small Interface), SAS (Serial Attached SCSI), PCI (Peripheral Component Interconnection), PCIe (PCI express), IEEE 1394, USB (Universal Serial Bus), SD (Secure Digital) card, MMC (Multi-Media Card), eMMC (embedded Multi-Media Card), UFS (Universal Flash Storage), and CF (Compact Flash) card.

The flash interface 1202 may provide an interface between the flash memory 1100 and the memory controller 1200. For example, the write or read data may be transferred to or received from the flash memory 1100 through the flash interface 1202. The flash interface 1202 may provide the command and the address to the flash memory 1100. Also, the flash interface 1202 may provide the data read from the flash memory 1100 to the memory controller 1200.

The control unit 1210 may include a central processing unit or a microprocessor and may control an overall operation of the memory controller 1200. The control unit 1210 may drive firmware loaded to the work memory 1220 to control the memory controller 1200.

The work memory 1220 may be implemented with various kinds of memories. For example, the work memory 1220 may be implemented with at least one of a cache memory, a DRAM, an SRAM, a PRAM, and a flash memory. The work memory 1220 may drive a flash translation layer FTL under control of the control unit 1210.

The off cell counter 1250 may compare the number of off cells provided from the flash memory 1100 and a reference value and may determine whether the block continuous-write is possible, based on the comparison result. For example, when the number of off cells is smaller than the reference value, the off cell counter 1250 may determine that the block continuous-write is possible. In contrast, when the number of off cells is equal to or greater than the reference value, the off cell counter 1250 may determine that the block continuous-write operation is not possible.

The storage device 1000 according to example embodiments of the present disclosure may control the block continuous-write operation of the flash memory 1100. Before performing the block continuous-write operation, the storage device 1000 may determine whether the block continuous-write is possible. The flash memory 1100 may verify whether the memory cells connected with the free word line are off cells, by using the free word line checker 1161. The memory controller 1200 may determine whether the block continuous-write is possible, by using the off cell information provided from the flash memory 1100.

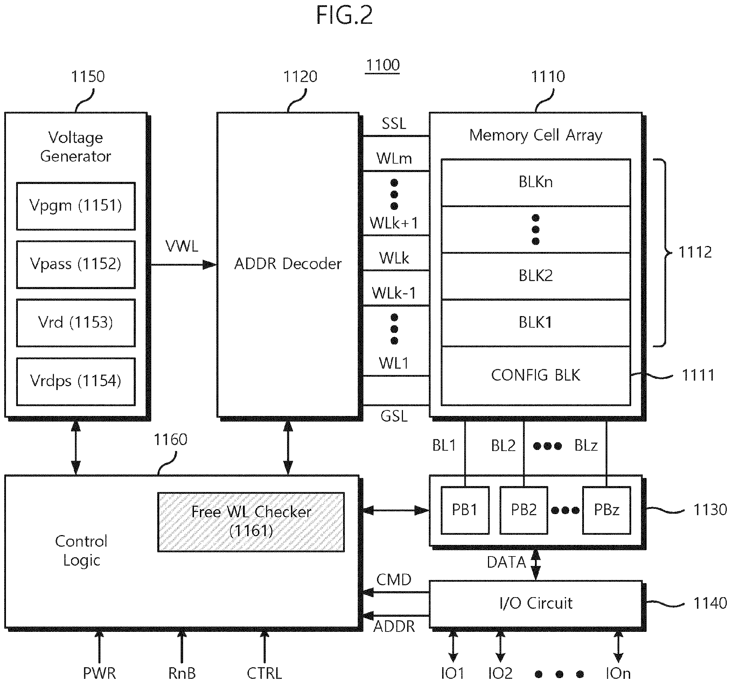

FIG. 2 is a block diagram illustrating a flash memory illustrated in FIG. 1. Referring to FIG. 2, the flash memory 1100 may include the memory cell array 1110, an address decoder 1120, a page buffer circuit 1130, an input/output circuit 1140, a voltage generator 1150, and/or control logic 1160.

The memory cell array 1110 may include the memory blocks. The memory blocks may include a configuration block 1111 that stores configuration data and data blocks (BLK1 to BLKn) 1112 that store normal data. The configuration data may be loaded to the peripheral circuit 1115 when the flash memory 1100 is booted up. Each of the data blocks may include a plurality of memory cells. Multi-bit data may be stored in each of the memory cells.

The memory cell array 1110 may be formed in a direction perpendicular to a substrate. A gate electrode layer and an insulation layer may be alternately deposited on the substrate. Each of the memory blocks (e.g., the memory block BLK1) may be connected with a string selection line SSL, a plurality of word lines WL1 to WLm, and a ground selection line GSL.

The address decoder 1120 may be connected with the memory cell array 1110 through the selection lines SSL and GSL and the word lines WL1 to WLm. The address decoder 1120 may select a word line in the program or read operation. The address decoder 1120 may receive a word line voltage VWL from the voltage generator 1150 and may provide the selected word line with a program voltage or a read voltage.

The page buffer circuit 1130 may be connected with the memory cell array 1110 through bit line BL1 to BLz. The page buffer circuit 1130 may temporarily store data to be programmed in the memory cell array 1110 or data read from the memory cell array 1110. The page buffer circuit 1130 may include page buffer PB1 to PBz that are respectively connected with the bit lines BL1 to BLz. Each page buffer may include a plurality of latches for the purpose of storing or reading multi-bit data.

The input/output circuit 1140 may be connected with the page buffer circuit 1130 through data lines internally and may be connected with the memory controller 1200 (refer to FIG. 1) through input/output lines IO1 to IOn externally. During the program operation, the input/output circuit 1140 may receive program data from the memory controller 1200. During the read operation, the input/output circuit 1140 may provide the memory controller 1200 with the data read from the memory cell array 1110.

The voltage generator 1150 may be supplied with an internal power from the control logic 1160 and may generate the word line voltage VWL necessary to read or write data. The word line voltage VWL may be provided to a selected word line sWL or an unselected word line uWL through the address decoder 1120.

The voltage generator 1150 may include a program voltage (Vpgm) generator 1151 and a pass voltage (Vpass) generator 1152. The program voltage generator 1151 may generate a program Vpgm that is provided to the selected word line sWL during the program operation. The pass voltage generator 1152 may generate a pass voltage Vpass that is provided to the selected word line sWL and the unselected word line uWL.

The voltage generator 1150 may further include a read voltage (Vrd) generator 1153 and a read pass voltage (Vrdps) generator 1154. The read voltage generator 1153 may generate a selection read voltage Vrd that is provided to the selected word line sWL during the read operation. The read pass voltage generator 1154 may generate a read pass voltage Vrdps that is provided to the unselected word line uWL. The read pass voltage Vrdps may refer to a voltage sufficient to turn on memory cells connected with the unselected word line uWL during the read operation.

The control logic 1160 may control the read, write, and erase operations of the flash memory 1100 by using a command CMD, an address ADDR, and the control signal CTRL provided from the memory controller 1200. The address ADDR may include a block selection address for selecting one memory block, a row address for selecting one page, and a column address for selecting one memory cell (or one column).

While the read, write, or erase operation is internally performed, the control logic 1160 may set the ready/busy signal RnB to the busy state (e.g., logic low). After the read, write, or erase operation is completed, the control logic 1160 may set the ready/busy signal RnB to the ready state (e.g., logic high). When the control logic 1160 receives a command for a free word line check from the memory controller 1200, the control logic 1160 may set the ready/busy signal RnB to the busy state and may internally perform a free word line check operation during one busy signal period.

The control logic 1160 may include the free word line checker 1161. When the flash memory 1100 is booted up, the free word line checker 1161 may receive a digital code from the configuration block 1111 and may perform the free word line check operation in real time. The free word line checker 1161 may verify whether memory cells connected with a free word line are off cells. The flash memory 1100 may provide the off cell information generated by the free word line checker 1161 to the memory controller 1200.

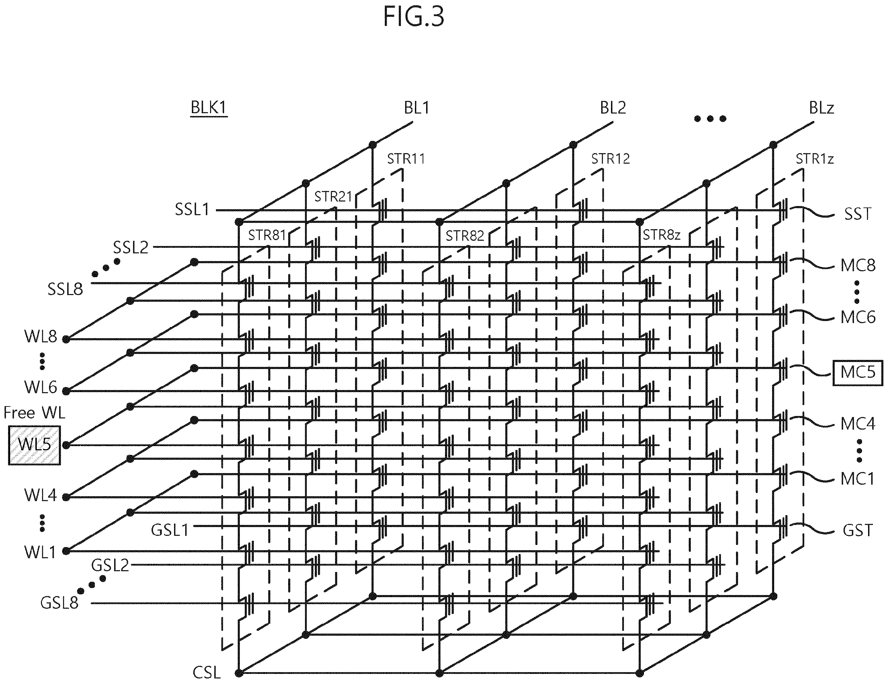

FIG. 3 is a circuit diagram illustrating the memory block BLK1 of a memory cell array of FIG. 2. First to eighth word lines WL1 to WL8, first to eighth memory cells MC1 to MC8, first to z-th bit lines BL1 to BLz, and first to eighth ground selection lines GSL1 to GSL8, and 11st to 8z-th cell strings STR11 to STR8z are illustrated in FIG. 3 as an example.

Referring to FIG. 3, in the memory block BLK1, a plurality of cell strings STR11 to STR8z may be formed between the bit lines BL1 to BLz and a common source line CSL. Each cell string includes a string selection transistor SST, a plurality of memory cells MC1 to MC8, and a ground selection transistor GST.

The string selection transistors SST may be connected with string selection lines SSL1 to SSL8. The ground selection transistors GST may be connected with ground selection lines GSL1 to GSL8. The string selection transistors SST may be connected with the bit lines BL1 to BLz, and the ground selection transistors GST may be connected with the common source line CSL.

The first to eighth word lines WL1 to WL8 may be connected with the plurality of memory cells MC1 to MC8 in a row direction. The first to z-th bit lines BL1 to BLz may be connected with the plurality of memory cells MC1 to MC8 in a column direction. First to z-th page buffers PB1 to PBz may be connected with the first to z-th bit lines BL1 to BLz.

The first word line WL1 may be placed above the first to eighth ground selection lines GSL1 to GSL8. The first memory cells MC1 that are placed at the same height from the substrate may be connected with the first word line WL1. Likewise, the second to eighth memory cells MC2 to MC8 that are placed at the same heights from the substrate may be respectively connected with the second to eighth word lines WL2 to WL8.

The first to fifth memory cells MC1 to MC5 may be erased memory cells. The sixth to eighth memory cells MC6 to MC8 may be programmed memory cells. The first to fifth word lines WL1 to WL5 may be erased word lines, and the sixth to eighth word lines WL6 to WL8 may be programmed word lines. The fifth word line WL5 may be a free word line. The fifth memory cells MC5 that are erased memory cells may be used to check whether the block continuous-write is possible.

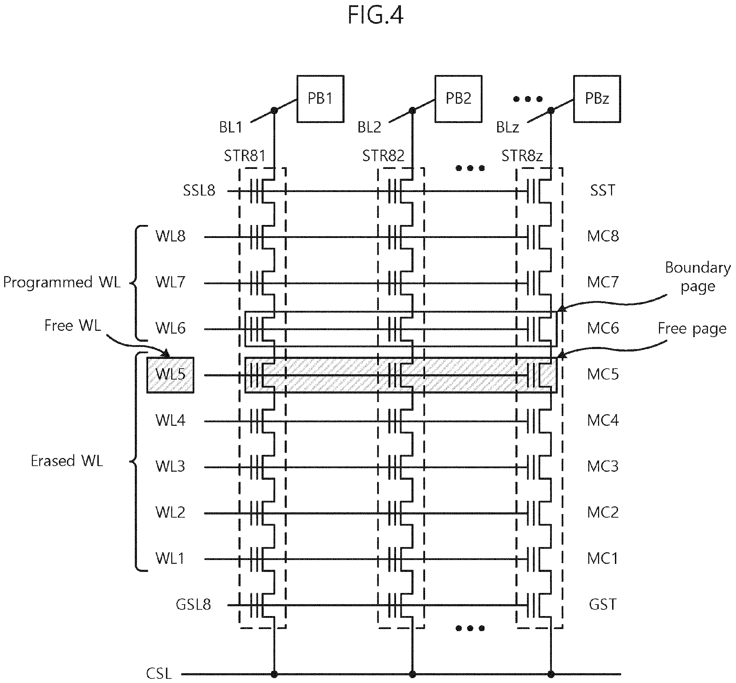

FIG. 4 is a circuit diagram illustrating cell strings selected by the eighth string selection line SSL8 from among cell strings of the memory block BLK1 illustrated in FIG. 3. 81st to 8z-th cell strings STR81 to STR8z may be selected by the eighth string selection line SSL8. The 81st to 8z-th cell strings STR81 to STR8z may be respectively connected with the first to z-th bit lines BL1 to BLz. First to z-th page buffers PB1 to PBz may be respectively connected with the first to z-th bit lines BL1 to BLz.

The 81st cell string STR81 is connected with the first bit line BL1 and the common source line CSL. The string selection transistor SST selected by the eighth string selection line SSL8, the first to eighth memory cells MC1 to MC8 connected with the first to eighth word lines WL1 to WL8, and the ground selection transistor GST selected by the eighth ground selection line GSL8 may be included in the 81st cell string STR81. Likewise, the 82st cell string STR82 may be connected with the second bit line BL2 and the common source line CSL, and the 8z-th cell string STR8z may be connected with the z-th bit line BLz and the common source line CSL.

The first to fifth word lines WL1 to WL5 may be erased word lines, and the sixth to eighth word lines WL6 to WL8 may be programmed word lines. Memory cells that are selected by one string selection line and are connected with one word line may constitute one page. For example, memory cells that are connected with the first word line WL1 may constitute 8 pages.

An example in which memory cells selected by the eighth string selection line SSL8 and connected with the fifth word line WL5 constitute one free page is illustrated in FIG. 4. The free page refers to a page for checking whether the block continuous-write is possible. Memory cells selected by the eighth string selection line SSL8 and connected with the sixth word line WL6 may constitute one boundary page. The boundary page may refer to a page that is lastly programmed. The block continuous-write operation may be performed from a page following the boundary page.

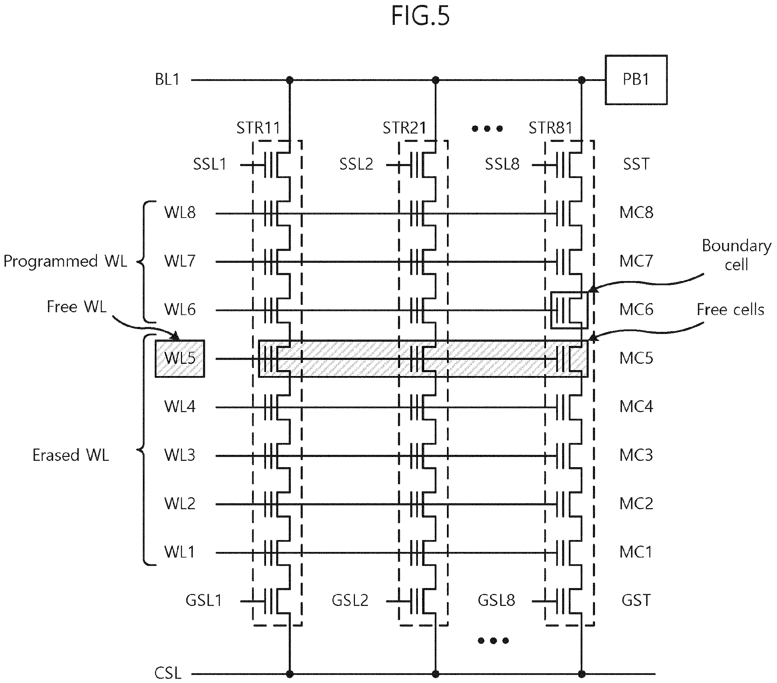

FIG. 5 is a circuit diagram illustrating the cell strings STR11 to STR81 connected with the first bit line BL1 and the common source line CSL from among cell strings of the memory block BLK1 illustrated in FIG. 3. The first page buffer PB1 may be connected with the first bit line BL1. The first to eighth cell strings STR11 to STR81 may be selected by the first to eighth string selection lines SSL1 to SSL8.

For example, the 11st cell string STR11 may be selected by the first string selection line SSL1. The 11st cell string STR11 includes the string selection transistor SST selected by the first string selection line SSL1, the first to eighth memory cells MC1 to MC8 controlled by the first to eighth word lines WL1 to WL8, and the ground selection transistor GST selected by the first ground selection line GSL1.

Memory cells connected with the first to fifth word lines WL1 to WL5 may be erased cells. Memory cells connected with the sixth to eighth word lines WL6 to WL8 may be programmed cells. The memory cells MC5 connected with the fifth word line WL5 may be erased cells and may be free cells for checking whether the block continuous-write is possible. A memory cell connected with the sixth word line WL6 and selected by the eighth string selection line SSL8 may be a boundary cell.

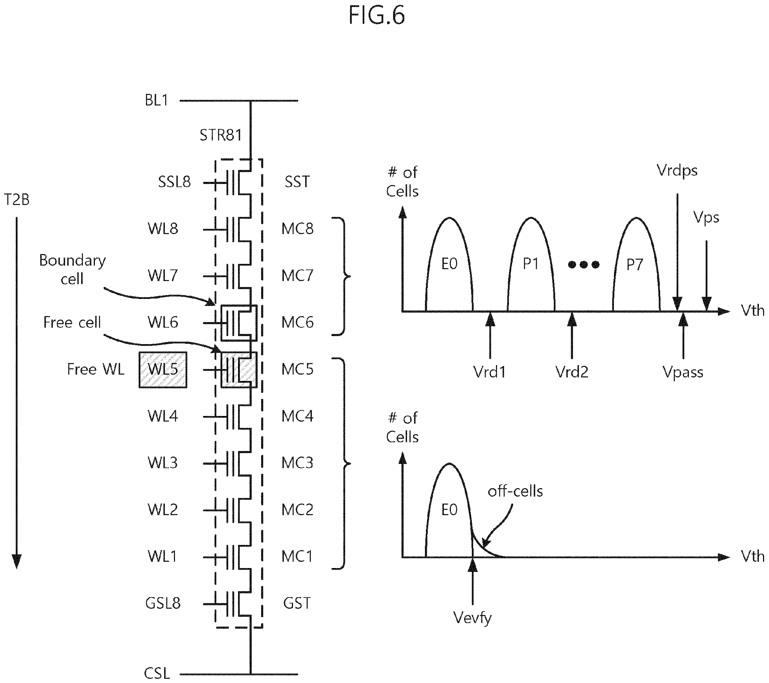

FIG. 6 is a diagram illustrating threshold voltage distributions of memory cells illustrating in FIG. 3. In FIG. 6, a horizontal axis represents a threshold voltage Vth, and a vertical axis represents the number of memory cells. FIG. 6 shows an example in which 3-bit data are stored in one memory cell. A 3-bit memory cell may have one of eight states E0 and P1 to P7 according to threshold voltage distributions. Herein, E0 represents an erase state, and P1 to P7 represent program states.

Vrd1, Vrd2, etc. that are selection read voltages are used to read the erase and program states of the memory cells. Vpass that is a program pass voltage may be provided to a selected word line and an unselected word line in the program operation. In the free word line check operation, the erase verify voltage Vevfy may be provided to a free word line (e.g., WL5), and the pass voltage Vps or the read pass voltage Vrdps may be provided to the remaining word lines. The pass voltage Vps or the read pass voltage Vrdps may be a voltage sufficient to turn on memory cells.

The erase verify voltage Vevfy is a voltage for verifying the erase state E0 of memory cells. When the erase verify voltage Vevfy is applied to the free word line WL5, memory cells having the erase state E0 are turned on and are referred to as an "on cell", and memory cells being out of the erase state E0 are turned off and are referred to as an "off cell".

The flash memory 1100 may experience the pass voltage disturbance and the program voltage disturbance during the program operation. The pass voltage disturbance is caused by the stress that memory cells connected with an unselected word line experience. The program voltage disturbance is caused by the stress that memory cells connected with a selected word line but belonging to an unselected cell string experience.

The flash memory 1100 may continuously apply the program pass voltage to the erased word line during the program operation. In some example embodiments, the memory cells connected with the first to fifth word lines WL1 to WL5 may experience the pass voltage disturbance. The pass voltage disturbance may allow threshold voltages of erased memory cells to be greater than the erase verify voltage Vevfy. That is, the erased memory cells may become off cells.

The storage device 1000 according to example embodiments of the present disclosure may determine whether the block continuous-write is possible, by verifying whether memory cells connected with the free word line are off cells. The storage device 1000 may check the number of off cells among the memory cells of the free word line and may determine whether the block continuous-write is possible, based on the check result.

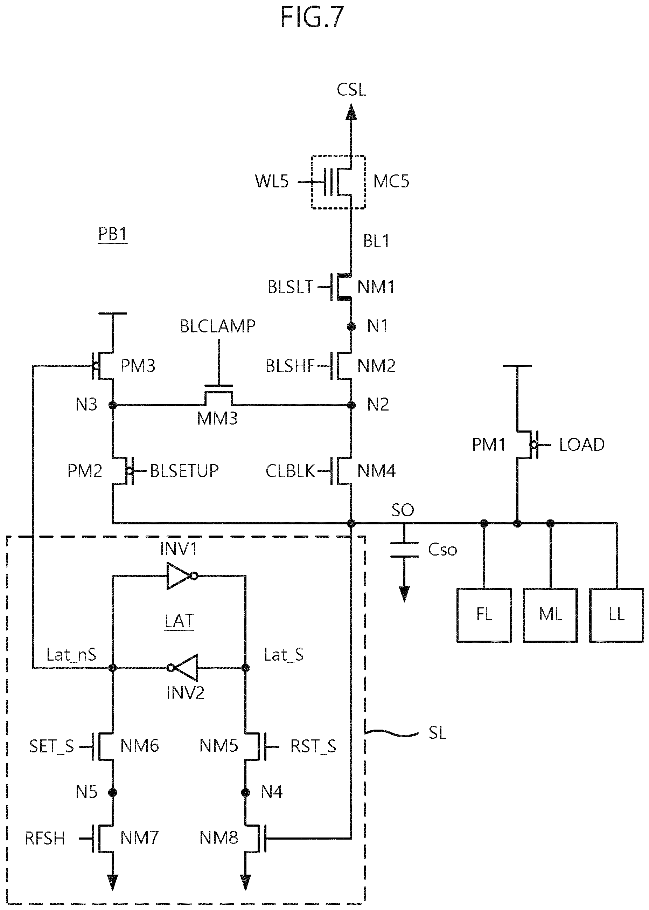

FIG. 7 is a circuit diagram illustrating the first page buffer PB1 illustrated in FIG. 2. Referring to FIG. 7, the first page buffer PB1 is connected with the first bit line BL1. The fifth memory cell MC5 may be connected with the first bit line BL1. The fifth word line WL5 may include the fifth memory cell MC5. The first bit line BL1 may be connected with the common source line CSL through the fifth memory cell MC5.

A first NMOS transistor NM1 may be included between the first bit line BL1 and a first node N1. The first NMOS transistor NM1 may refer to a bit line selection transistor that is driven by a bit line selection signal BLSLT. The bit line selection transistor may be implemented with a high-voltage transistor. The bit line selection transistor may be disposed in a high-voltage area.

A second NMOS transistor NM2 may be included between the first node N1 and a second node N2. The second NMOS transistor NM2 may refer to a bit line shut-off transistor that is driven by a bit line shut-off signal BLSHF. A third NMOS transistor NM3 may be included between the second node N2 and a third node N3. The third NMOS transistor NM3 may refer to a bit line clamping transistor that is driven by a bit line clamping control signal BLCLAMP. A fourth NMOS transistor NM4 may be included between a sensing node SO and the second node N2. The fourth NMOS transistor NM4 may refer to a bit line connection transistor that is driven by a bit line connection control signal CLBLK.

A first PMOS transistor PM1 may be included between a power terminal and the sensing node SO. The first PMOS transistor PM1 may refer to a precharge load transistor that is driven by a load signal LOAD. A second PMOS transistor PM2 may be included between the sensing node SO and the third node N3. The second PMOS transistor PM2 may refer to a bit line setup transistor that is driven by a bit line setup signal BLSETUP. A third PMOS transistor PM3 may be included between the power terminal and the third node N3. The third PMOS transistor PM3 may refer to a precharge transistor that is driven by an inversion latch node Lat_nS.

A sensing latch SL, a force latch FL, an upper bit latch ML, and a lower bit latch LL may be connected with the sensing node SO. The sensing latch SL may store a result of sensing a threshold voltage of the fifth memory cell MC5 in the erase verify operation. Also, the sensing latch SL may be used to apply a bit line precharge voltage to the first bit line BL1 in the erase verify operation. The force latch FL may be used to improve a threshold voltage distribution in the program operation. The upper bit latch ML and the lower bit latch LL may be used to store data input from the outside in the program operation.

The sensing latch SL may include a latch LAT connected between a latch node Lat_S and the inversion latch node Lat_nS. The latch LAT may include a first inverter INV1 and a second inverter INV2. An input terminal of the first inverter INV1 and an output terminal of the second inverter INV2 may be connected with the inversion latch node Lat_nS. An output terminal of the first inverter INV1 and an input terminal of the second inverter INV2 may be connected with the latch node Lat_S.

The inversion latch node Lat_nS may be connected with a gate terminal of the third PMOS transistor PM3. When the inversion latch node Lat_nS is at the low level, the third PMOS transistor PM3 may be turned on, and thus, the third node N3 may be set with a power supply voltage level. When the inversion latch node Lat_nS is at the high level, the power terminal and the third node N3 may be disconnected from each other.

A fifth NMOS transistor NM5 may be included between the latch node Lat_S and a fourth node N4. The fifth NMOS transistor NM5 may be used to reset the latch node Lat_S in response to a latch reset signal RST_S. The latch reset signal RST_S may be provided from the control logic 1160 (refer to FIG. 2). A sixth NMOS transistor NM6 may be included between the inversion latch node Lat _nS and a fifth node N5. The sixth NMOS transistor NM6 may be used to set the latch node Lat_S in response to a latch set signal SET_S. The latch set signal SET_S may be provided from the control logic 1160 (refer to FIG. 2).

A seventh NMOS transistor NM7 may be included between the fifth node N5 and a ground terminal. The seventh NMOS transistor NM7 may adjust a voltage level of the fifth node N5 in response to a refresh signal RFSH. The refresh signal RFSH may be provided from the control logic 1160 (refer to FIG. 2). An eighth NMOS transistor NM8 may be included between the fourth node N4 and the ground terminal. The eighth NMOS transistor NM8 may adjust a voltage level of the fourth node N4 in response to a voltage level of the sensing node SO.

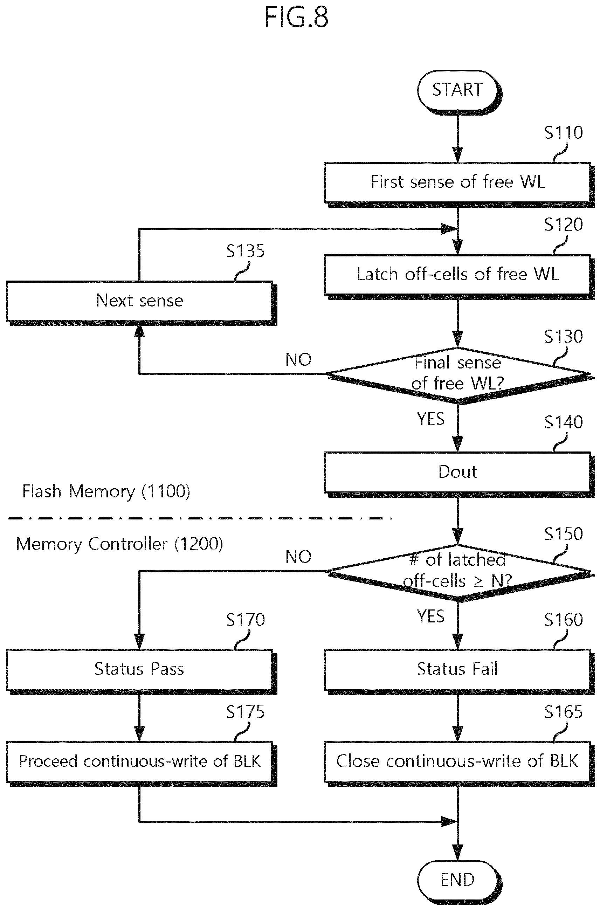

FIG. 8 is a flowchart for describing a block continuous-write operation of a storage device illustrated in FIG. 1. The block continuous-write means an operation of performing the program operation to be continuous to the remaining erased word lines when only some of word lines in one memory block are programmed and terminated. The storage device 1000 according to example embodiments of the present disclosure may determine whether the block continuous-write is possible, by verifying off cells connected with the free word line.

In operation S110, the free word line checker 1161 performs a first sensing operation of the free word line. The first sensing operation of the free word line may be performed with respect to a first page among a plurality of pages belonging to the free word line. A page targeted for the first sensing operation may be a next page of the boundary page.

In operation S120, the free word line checker 1161 may allow a result of the first sensing operation to be stored in the sensing latch SL (refer to FIG. 7). For example, the free word line checker 1161 may store an off cell check result for the fifth memory cell MC5 in the latch node Lat_S of the first page buffer PB1. When the fifth memory cell MC5 is the off cell, the sensing node SO may maintain a high-level state, and thus, the latch node Lat_S may have a value of "0". When the latch node Lat_S is at the low level, the inversion latch node Lat_nS is set with the high level. When the inversion latch node Lat_nS is at the high level, the third PMOS transistor PM3 may be turned off; in some example embodiments, the sensing node SO is not precharged any longer.

In operation S130, the free word line checker 1161 determines whether the sensing operation of the free word line is a final sensing operation. For example, the free word line checker 1161 determines whether the current sensing operation is a sensing operation targeted for the eighth page. When the sensing operation of the free word line is not the final sensing operation (No), the sensing operation of the next page (e.g., the second sensing operation) is performed (S135). When the sensing operation of the free word line is the final sensing operation (Yes), operation S140 is performed.

In operation S140, the free word line checker 1161 may output the off cell information of the free word line. That is, the flash memory 1100 may provide the off cell information of the free word line to the memory controller 1200. The off cell information of the free word line may refer to information about the number of off cells latched in the page buffers PB1 to PBz.

In operation S150, the off cell counter 1250 of the memory controller 1200 may compare the number of latched off cells and the reference value and may determine whether the block continuous-write is possible, based on the comparison result. For example, the off cell counter 1250 may determine whether the number of latched off cells is equal to or greater than "N". Herein, "N" may be a given natural number and may be used as a reference value for determining whether to continue to do the block continuous-write operation.

When the number of latched off cells is equal to or greater than "N" (Yes), in operation S160, the off cell counter 1250 may determine that a status fail occurs. In operation S165, the memory controller 1200 may close the block continuous-write depending on a status fail determination result of the off cell counter 1250.

When the number of latched off cells is smaller than "N" (No), in operation S170, the off cell counter 1250 may determine that a status pass occurs. In operation S175, the memory controller 1200 may continue to do the block continuous-write depending on a status pass determination result of the off cell counter 1250.

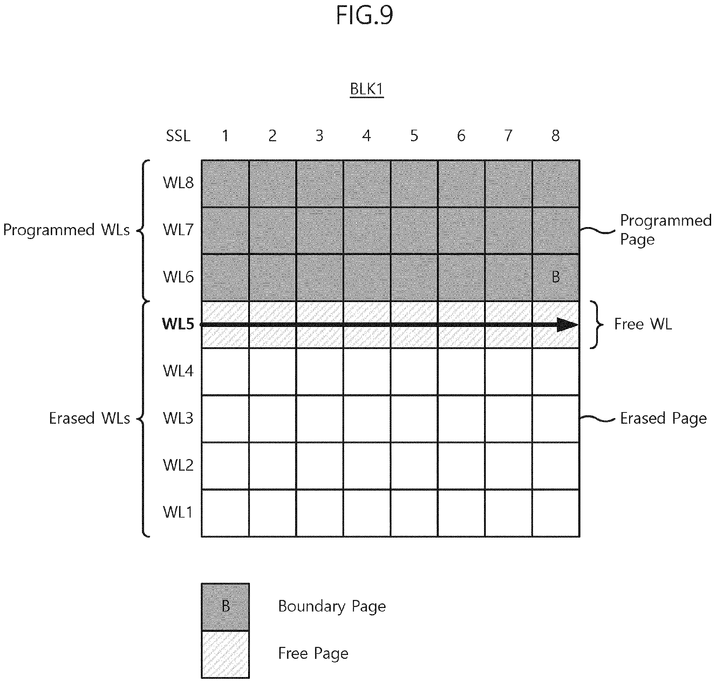

FIG. 9 is a diagram illustrating a method in which a free word line checker illustrated in FIG. 1 checks whether to continue to do a block continuous-write by using one word line. Referring to FIG. 9, the first to fifth word lines WL1 to WL5 are erased word lines. The sixth to eighth word lines WL6 to WL8 are programmed word lines. The fifth word line WL5 is a free word line for checking whether to continue to do the block continuous-write.

The free word line checker 1161 may perform the free word line check operation from a next page of a lastly programmed boundary page. In the example of FIG. 9, the boundary page may be the eighth page of the sixth word line WL6. The eighth page of the sixth word line WL6 may be selected by the eighth string selection line SSL8.

The free word line checker 1161 may perform the free word line check operation sequentially from the first page to the eighth page of the fifth word line WL5. The first page of the fifth word line WL5 may be selected by the first string selection line SSL1, and the eighth page of the fifth word line WL5 may be selected by the eighth string selection line SSL8.

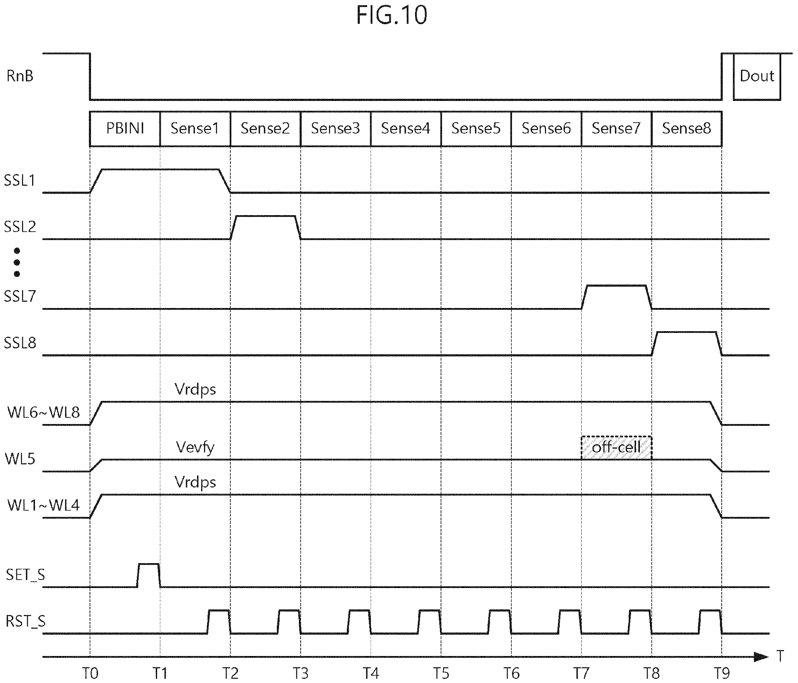

FIG. 10 is a timing diagram illustrating a method for checking whether to continue to do the block continuous-write of the diagram illustrated in FIG. 9. Referring to FIG. 10, the free word line checker 1161 may perform a free word line check operation based on a result of accumulating sensing results of two or more pages during one busy signal period.

The free word line check operation may include a page buffer initialization operation PBINI and first to eighth page sensing operations Sense1 to Sense8. In the page buffer initialization operation PBINI, the latch set signal SET_S may be provided to the page buffers PB1 to PBz. In the first to eighth page sensing operations Sense1 to Sense8, the latch reset signal RST_S may be provided to the page buffers PB1 to PBz.

The page buffer initialization operation PBINI may be performed during a time period from T0 to T1. During the page buffer initialization operation PBINI, the first string selection line SSL1 may be activated. The read pass voltage Vrdps may be applied to the first to fourth word lines WL1 to WL4 and the sixth to eighth word lines WL6 to WL8. The erase verify voltage Vevfy may be applied to the fifth word line WL5. When the latch set signal SET_S is provided to the page buffer PB1 (refer to FIG. 7), the inversion latch node Lat_nS is set with low level, and the latch node Lat_S is set with the high level.

The first page sensing operation Sense1 may be performed during a time period from T1 to T2. During the first page sensing operation Sense1, the first string selection line SSL1 may be in an active state. Because the inversion latch node Lat_nS is at the low level during the first page sensing operation Sense1, the third PMOS transistor PM3 is turned on, and the sensing node SO is precharged. In the first page sensing operation Sense1, the read pass voltage Vrdps is applied to the first to fourth word lines WL1 to WL4 and the sixth to eighth word lines WL6 to WL8, and the erase verify voltage Vevfy is applied to the fifth word line WL5.

When the latch reset signal RST_S is provided to the page buffer PB1, depending on a voltage level of the sensing node SO, the inversion latch node Lat_nS may maintain the high level or may be set with the low level. Assuming that the fifth memory cell MC5 is an on cell based on the erase verify voltage Vevfy, the sensing node SO is set with the low level. When the sensing node SO is at the low level, the eighth NMOS transistor NM8 is turned off; in some example embodiments, the latch node Lat_S maintains the high level, and the inversion latch node Lat_nS maintains the low level.

The second page sensing operation Sense2 may be performed during a time period from T2 to T3. During the second page sensing operation Sense2, the second string selection line SSL2 may be in an active state. Because the inversion latch node Lat_nS is at the low level during the second page sensing operation Sense2, the sensing node SO is precharged. Assuming that the fifth memory cell MC5 is an on cell based on the erase verify voltage Vevfy, when the latch reset signal RST_S is provided to the page buffer PB1, the latch node Lat_S maintains the high level, and the inversion latch node Lat_nS maintains the low level. As in the above description, the third to sixth page sensing operations Sense3 to Sensed may be performed during a time period from T4 to T7.

The seventh page sensing operation Sense7 may be performed during a time period from T7 to T8. During the seventh page sensing operation Sense7, the seventh string selection line SSL7 may be in an active state. Because the inversion latch node Lat_nS is at the low level during the seventh page sensing operation Sense7, the sensing node SO is precharged. It is assumed that the fifth memory cell MC5 is an off cell based on the erase verify voltage Vevfy.

The latch reset signal RST_S is provided to the page buffer PB1. Assuming that the fifth memory cell MC5 is an off cell, the sensing node SO maintains the precharge state. When the sensing node SO is at the high level, the eighth NMOS transistor NM8 is turned on. In some example embodiments, the latch node Lat_S changes from the high level to the low level, the inversion latch node Lat_nS changes from the low level to the high level.

The eighth page sensing operation Sense8 may be performed during a time period from T8 to T9. During the eighth page sensing operation Sense8, the eighth string selection line SSL8 may be in an active state. Because the inversion latch node Lat_nS is at the high level during the eighth page sensing operation Sense8, the third PMOS transistor PM3 is turned off, and the sensing node SO is not precharged any longer.

The latch reset signal RST_S is provided to the page buffer PB1. In some example embodiments, because the sensing node SO is not precharged, that is, is at the low level, the eighth NMOS transistor NM8 is turned off. As the eighth NMOS transistor NM8 is turned off, the latch node Lat_S maintains the low level, and the inversion latch node Lat_nS maintains the high level.

The free word line checker 1161 may perform the free word line check operation sequentially from the first page to the eighth page of the fifth word line WL5. The first page of the fifth word line WL5 may be selected by the first string selection line SSL1, and the eighth page of the fifth word line WL5 may be selected by the eighth string selection line SSL8.

Through the above method, the free word line checker 1161 may verify whether memory cells connected with a free word line are off cells. When the ready/busy signal R/nB changes from the busy state to the ready state, the flash memory 1100 may output the off cell information generated by the free word line checker 1161 to the memory controller 1200.

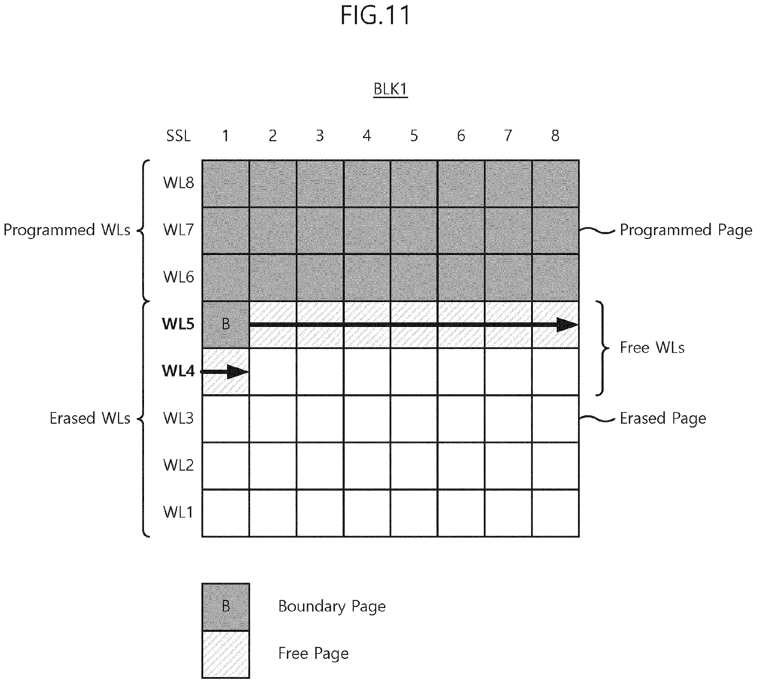

FIG. 11 is a diagram illustrating a method in which a free word line checker illustrated in FIG. 1 checks whether to continue to do a block continuous-write by using two word lines. Referring to FIG. 11, the first to fifth word lines WL1 to WL5 are erased word lines. The sixth to eighth word lines WL6 to WL8 are programmed word lines. The free word line for checking whether to continue to do the block continuous-write may include the fifth and fourth word lines WL5 and WL4.

A page connected with the first string selection line SSL1 from among pages of the fifth word line WL5 is a programmed boundary page. The remaining pages of the fifth word line WL5, which are connected with the second to eighth string selection lines SSL2 to SSL8, are erased pages. The free word line checker 1161 may perform the free word line check operation from a next page of the boundary page.

The free word line checker 1161 may perform the free word line check operation sequentially from the second page of the fifth word line WL5 to the first page of the fourth word line WL4. The second page of the fifth word line WL5 may be selected by the second string selection line SSL2, and the first page of the fourth word line WL4 may be selected by the first string selection line SSL1.

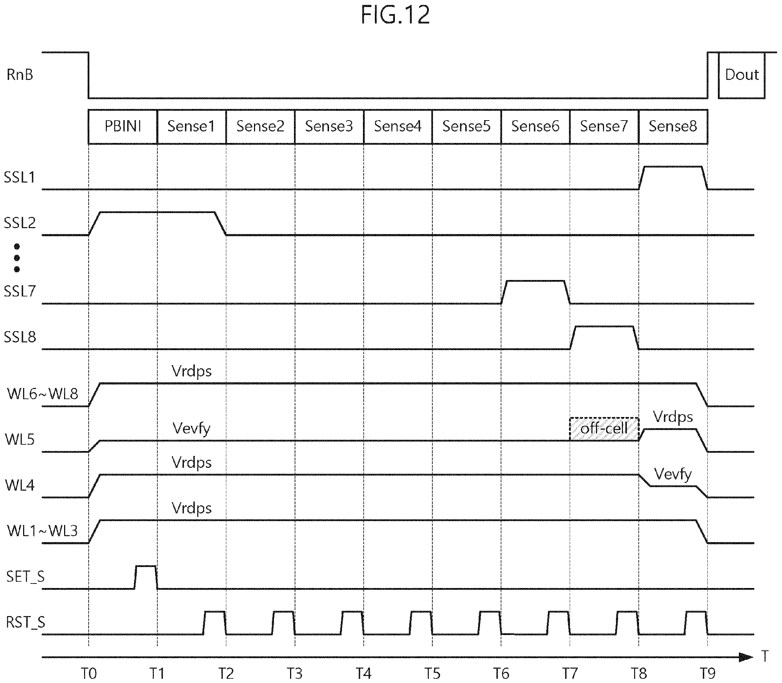

FIG. 12 is a timing diagram illustrating a method for checking whether to continue to do the block continuous-write of the diagram illustrated in FIG. 11. Referring to FIG. 12, the free word line checker 1161 may perform the free word line check operation based on a result of accumulating sensing results of two or more word line during one busy signal period.

The page buffer initialization operation PBINI may be performed during a time period from T0 to T1. During the page buffer initialization operation PBINI, the second string selection line SSL2 may be activated. The read pass voltage Vrdps may be applied to the first to fourth word lines WL1 to WL4 and the sixth to eighth word lines WL6 to WL8. The erase verify voltage Vevfy may be applied to the fifth word line WL5. When the latch set signal SET_S is provided to the page buffer PB1 (refer to FIG. 7), the inversion latch node Lat_nS is set with low level, and the latch node Lat_S is set with the high level.

The first page sensing operation Sense1 may be performed during a time period from T1 to T2. During the first page sensing operation Sense1, the second string selection line SSL2 may be in an active state. Because the inversion latch node Lat_nS is at the low level during the first page sensing operation Sense1, the third PMOS transistor PM3 is turned on, and the sensing node SO is precharged. In some example embodiments, the read pass voltage Vrdps are applied to the first to fourth word lines WL1 to WL4 and the sixth to eighth word lines WL6 to WL8, and the erase verify voltage Vevfy is applied to the fifth word line WL5.

When the latch reset signal RST_S is provided to the page buffer PB1, depending on a voltage level of the sensing node SO, the inversion latch node Lat_nS may maintain the high level or may be set with the low level. Assuming that the fifth memory cell MC5 is an on cell based on the erase verify voltage Vevfy, the sensing node SO is set with the low level. When the sensing node SO is at the low level, the eighth NMOS transistor NM8 is turned off. In some example embodiments, the latch node Lat_S maintains the high level, and the inversion latch node Lat_nS maintains the low level. As in the above description, the second to sixth page sensing operations Sense2 to Sensed may be performed during a time period from T2 to T7.

The seventh page sensing operation Sense7 may be performed during a time period from T7 to T8. During the seventh page sensing operation Sense7, the eighth string selection line SSL8 may be in an active state. Because the inversion latch node Lat_nS is at the low level during the seventh page sensing operation Sense7, the sensing node SO is precharged. It is assumed that the fifth memory cell MC5 is an off cell based on the erase verify voltage Vevfy. When the latch reset signal RST_S is provided to the page buffer PB1, the sensing node SO maintains the precharge state. When the sensing node SO is at the high level, the eighth NMOS transistor NM8 is turned on. In some example embodiments, the latch node Lat_S changes from the high level to the low level, the inversion latch node Lat_nS changes from the low level to the high level.

The eighth page sensing operation Sense8 may be performed during a time period from T8 to T9. During the eighth page sensing operation Sense8, the first string selection line SSL1 may be in an active state. Because the inversion latch node Lat_nS is at the high level during the eighth page sensing operation Sense8, the third PMOS transistor PM3 is turned off, and the sensing node SO is not precharged any longer.

Because the sensing node SO is not precharged, the eighth NMOS transistor NM8 is turned off even though the latch reset signal RST_S is provided to the page buffer PB1. As the eighth NMOS transistor NM8 is turned off, the latch node Lat_S maintains the low level, and the inversion latch node Lat_nS maintains the high level.

Through the above method, the free word line checker 1161 may verify whether memory cells connected with two or more free word lines are off cells. When the ready/busy signal R/nB changes from the busy state to the ready state, the flash memory 1100 may output the off cell information generated by the free word line checker 1161 to the memory controller 1200.

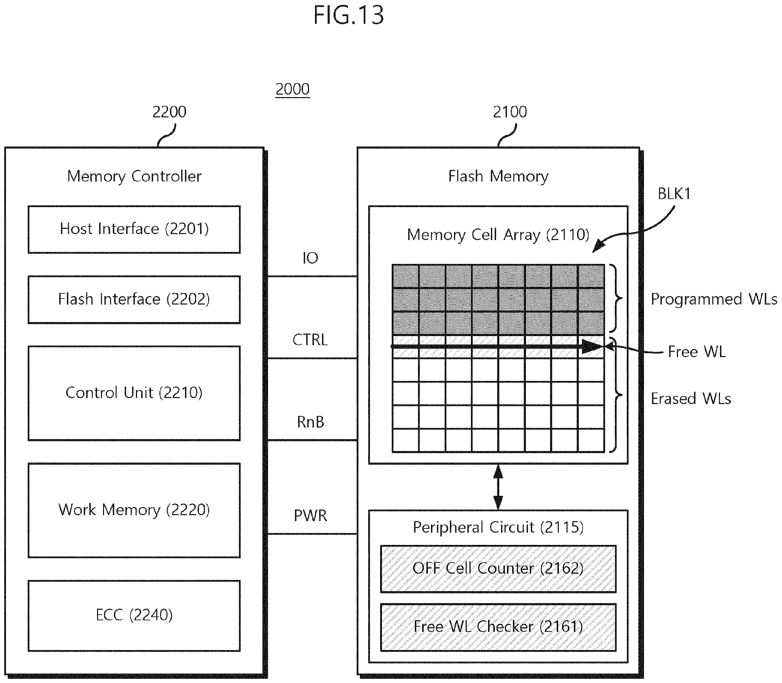

FIG. 13 is a block diagram illustrating a storage device according to other example embodiments of the present disclosure. Referring to FIG. 13, a storage device 2000 may include a flash memory 2100 and/or a memory controller 2200. The flash memory 2100 includes a memory cell array 2110 and/or a peripheral circuit 2115.

The memory cell array 2110 may include programmed word lines and erased word lines. The peripheral circuit 2115 may include a free word line checker 2161 and/or an off cell counter 2162. The free word line checker 2161 may verify whether memory cells connected with a free word line are off cells. The off cell counter 2162 may compare the number of off cells checked by the peripheral circuit 2115 and the reference value and may determine whether the block continuous-write is possible, based on the comparison result.

The memory controller 2200 may include a host interface 2201, a flash interface 2202, a control unit 2210, a work memory 2220, and/or an ECC circuit 2240. The host interface 2201 may provide an interface between the host and the memory controller 2200, and the flash interface 1202 may provide an interface between the flash memory 2100 and the memory controller 2200. The control unit 2210 may drive firmware loaded to the work memory 1220 to control the memory controller 2200. The ECC circuit 2240 may correct a fail bit or an error bit of data received from the flash memory 2100.

The storage device 2000 illustrated in FIG. 13 may perform both an operation for checking a free word line and an operation for determining whether the block continuous-write is possible, within the flash memory 2100. The flash memory 2100 may determine, in real time, whether the block continuous-write is possible, by verifying whether memory cells connected with the free word line are off cells, by using the free word line checker 2161 and the off cell counter 2162.

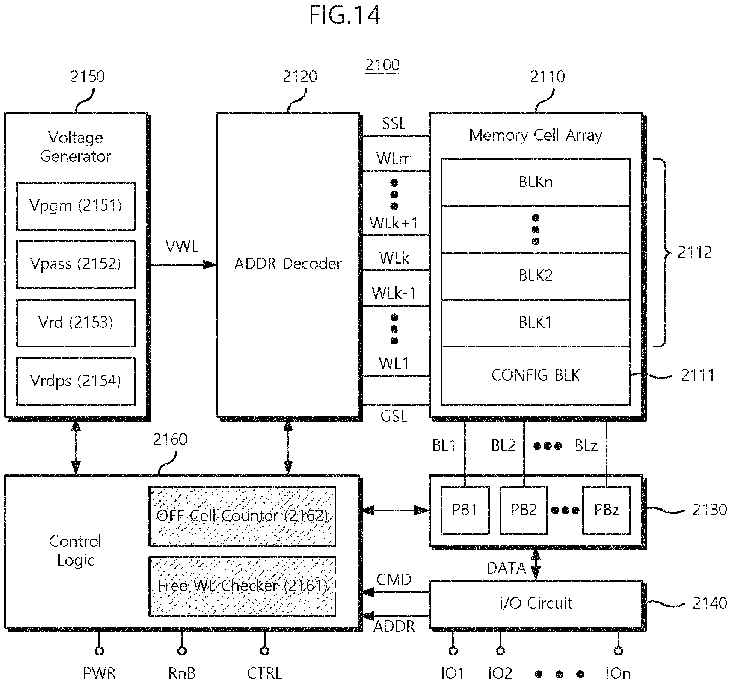

FIG. 14 is a block diagram illustrating a flash memory illustrated in FIG. 13. Referring to FIG. 14, the flash memory 2100 may include the memory cell array 2110, an address decoder 2120, a page buffer circuit 2130, a data input/output (I/O) circuit 2140, a voltage generator 2150, and/or control logic 2160.

The memory cell array 2110 may include a configuration block 2111 and data blocks (BLK1 to BLKn) 2112. The address decoder 2120 may be connected with the memory cell array 2110 through the selection lines SSL and GSL and the word lines WL1 to WLm. The page buffer circuit 2130 may be connected with the memory cell array 2110 through the bit line BL1 to BLz. The input/output circuit 2140 may be connected with the page buffer circuit 2130 through the data lines internally and may be connected with the memory controller 2200 (refer to FIG. 13) through the input/output lines IO1 to IOn externally.

The voltage generator 2150 may be supplied with an internal power from the control logic 2160 and may generate the word line voltage VWL necessary to read or write data. The voltage generator 2150 may include a program voltage generator 2151, a pass voltage generator 2152, a read voltage generator 2153, and a read pass voltage generator 2154.

The control logic 2160 may control the read, write, and erase operations of the flash memory 2100 by using the command CMD, the address ADDR, and the control signal CTRL provided from the memory controller 2200. The control logic 2160 may include the free word line checker 2161 and the off cell counter 2162. The free word line checker 2161 may verify whether memory cells connected with a free word line are off cells. The off cell counter 2162 may compare the number of off cells checked by the free word line checker 2161 and the reference value and may determine whether the block continuous-write is possible, based on the comparison result.

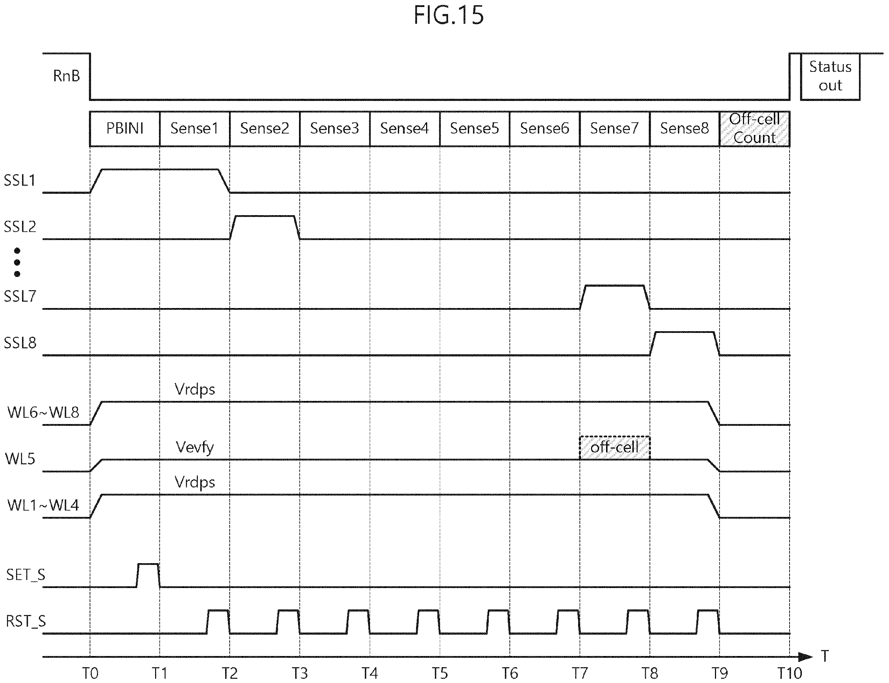

FIG. 15 is a timing diagram illustrating a method for checking whether to continue to do the block continuous-write of the flash memory illustrated in FIG. 14. Referring to FIG. 15, the flash memory 2100 may perform both an operation for checking a free word line and an operation for determining whether the block continuous-write is possible, during one busy signal period.

The free word line check operation may include the page buffer initialization operation PBINI and the first to eighth page sensing operations Sense 1 to Sense8. The first to eighth page sensing operations Sense1 to Sense8 may be performed to be identical to the scheme described with reference to FIG. 10. An off cell count operation may be performed after the eighth page sensing operation Sense8.

The off cell counter 2162 may compare the number of latched off cells and the reference value and may determine whether the block continuous-write is possible, based on the comparison result. For example, when the number of latched off cells is equal to or greater than "N", the off cell counter 2162 may not continue to do the block continuous-write; when the number of latched off cells is smaller than "N", the off cell counter 2162 may continue to do the block continuous-write. The flash memory 2100 may update the off cell count status information according to the free word line check operation and may provide the status information to the memory controller 2200.

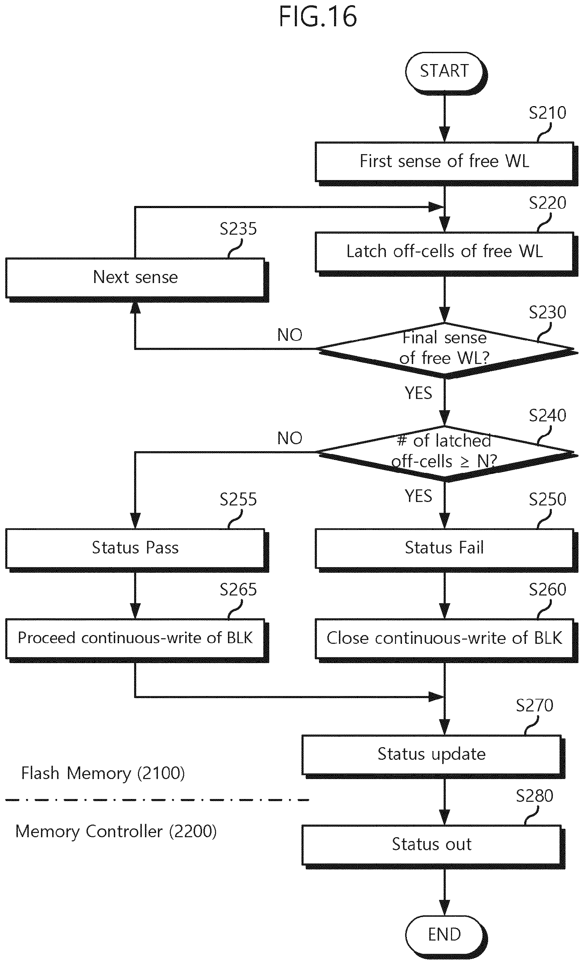

FIG. 16 is a flowchart for describing a block continuous-write operation of a flash memory illustrated in FIG. 14. The flash memory 2100 according to example embodiments of the present disclosure may determine whether to continue to do the block continuous-write, by checking off cells connected with the free word line and counting the number of off cells.

In operation S210, the free word line checker 2161 performs a first sensing operation of the free word line. In operation S220, under control of the free word line checker 2161, a result of checking off cells may be latched as a result of the first sensing operation. In operation S230, the free word line checker 2161 determines whether the sensing operation of the free word line is a final sensing operation. When the sensing operation of the free word line is not the final sensing operation (No), a next sensing operation (e.g., a second sensing operation) is performed (S235).

In operation S240, the free word line checker 2161 may generate status information of the free word line. The off cell counter 2162 may compare the number of latched off cells and the reference value and may determine whether the block continuous-write is possible, based on the comparison result.

When the number of latched off cells is equal to or greater than "N" (Yes), in operation S250, the off cell counter 2162 may determine that a status fail occurs. When the number of latched off cells is smaller than "N" (No), in operation S255, the off cell counter 2162 may determine that a status pass occurs.

In operation S260, the block continuous-write may be closed depending on a status fail determination result of the off cell counter 2162. In operation S265, the memory controller 2200 may continue to do the block continuous-write depending on a status pass determination result of the off cell counter 2162.

In operation S270, the off cell counter 2162 may perform a status update. The flash memory 2100 may update the off cell count status information according to the free word line check operation and may provide the update result to the memory controller 2200.

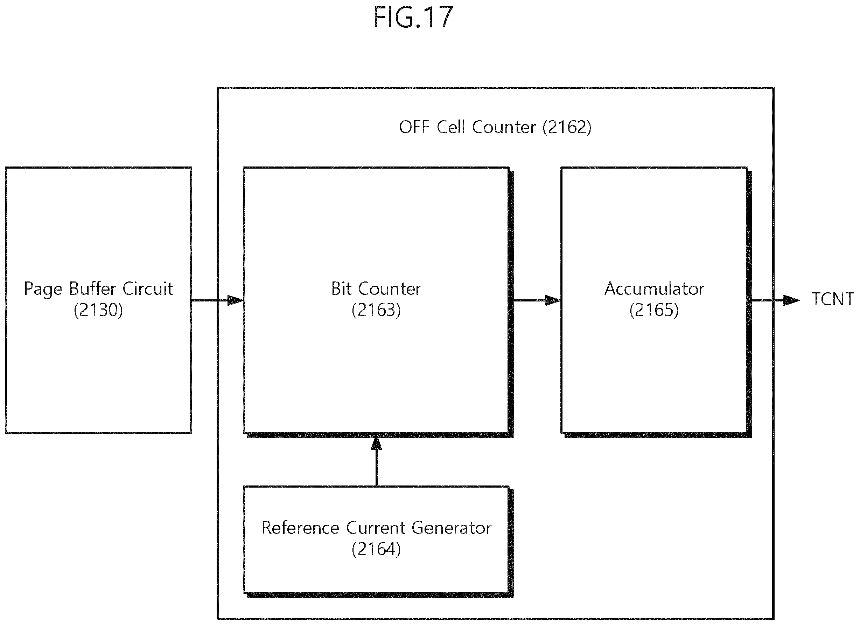

FIG. 17 is a block diagram illustrating an off cell counter illustrated in FIG. 14. Referring to FIG. 17, the off cell counter 2162 may include a bit counter 2163, a reference current generator 2164, and/or an accumulator 2165.

The bit counter 2163 may receive a sensing result of performing the first to eighth page sensing operations of the free word line from the page buffer circuit 2130. The first to eighth page sensing operations of the free word line may constitute an operation for verifying whether free memory cells are in an off cell state, with the erase verify voltage Vevfy provided to the free word line. The sensing result of performing the first to eighth page sensing operations may be respectively stored in sensing latches of page buffers of the page buffer circuit 2130.

The bit counter 2163 may receive the sensing result from the page buffer circuit 2130 and may compare the sensing result with a reference current provided from the reference current generator 2164. The bit counter 2163 may generate an off cell bit value as the comparison result. The accumulator 2165 may add the numbers of off cells by using the off cell bit value provided from the bit counter 2163. The accumulator 2165 may generate a total off cell count value TCNT. The off cell counter 2162 may compare the total off cell count value TCNT and the reference value and may determine whether the block continuous-write is possible, as the comparison result.

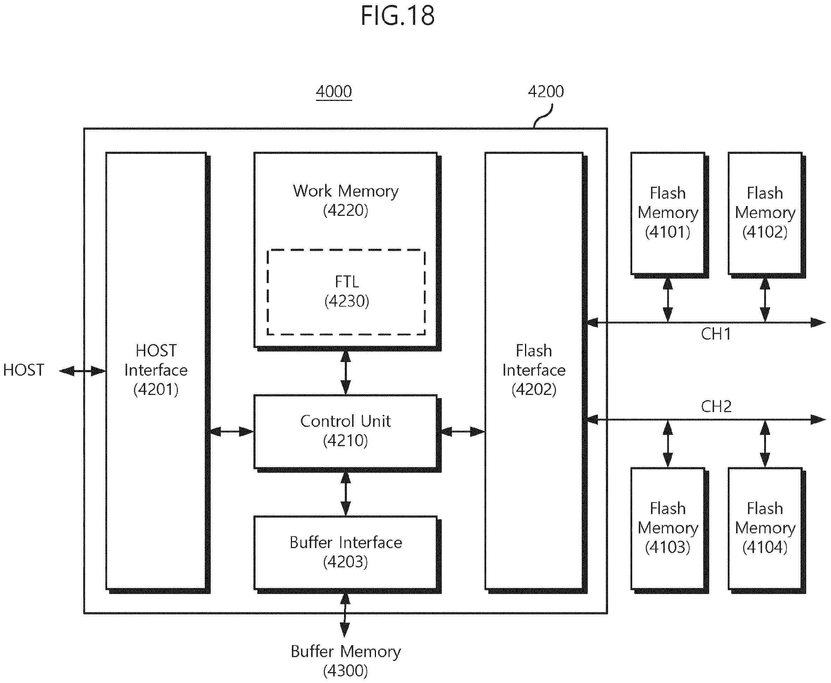

FIG. 18 is a block diagram illustrating an example in which a storage device according to example embodiments of the present disclosure is implemented with a solid state drive (SSD). Referring to FIG. 18, an SSD 4000 may include a plurality of flash memories 4101 to 4104 and/or an SSD controller 4200.

The first and second flash memories 4101 and 4102 may be connected with the SSD controller 4200 through a first channel CH1. The third and fourth flash memories 4103 and 4104 may be connected with the SSD controller 4200 through a second channel CH2. The number of channels connected with the SSD controller 4200 may be 2 or more. The number of flash memories connected with one channel may be 2 or more.

The SSD controller 4200 may include a host interface 4201, a flash interface 4202, a buffer interface 4203, a control unit 4210, and a work memory 4220. The work memory 4220 may be used to drive a flash translation layer (FTL) 4230.

The SSD controller 4200 may be connected with the host through the host interface 4201. Depending on a request of the host, the SSD controller 4200 may write data in the corresponding flash memory or may read data from the corresponding flash memory.

The SSD controller 4200 may be connected with the plurality of flash memories 4101 to 4104 through the flash interface 4202 and may be connected with a buffer memory 4300 through the buffer interface 4203. The flash interface 4202 may provide data, which are temporarily stored in the buffer memory 4300, to the flash memories through the channels CH1 and CH2. The flash interface 4202 may transfer the data read from the flash memories 4101 to 4104 to the buffer memory 4300.

The control unit 4210 may analyze and process the signal received from the host. The control unit 4210 may control the host or the flash memories 4101 to 4104 through the host interface 4201 or the flash interface 4202. The control unit 4210 may control operations of the flash memories 4101 to 4104 based on firmware for driving the SSD 4000.

The work memory 4220 may drive the flash translation layer 4230 under control of the control unit 4210. When the SSD 4000 is booted up, the flash translation layer 4230 may be loaded to the work memory 4220 from the flash memories 4101 to 4104. The flash translation layer 4230 may perform an address mapping operation, a garbage collection operation, a meta data management operation, etc. depending on a function implemented by the firmware.

The SSD controller 4200 may manage the block continuous-write operation by using the free word line check operation of the flash memories 4101 to 4104. The SSD controller 4200 may receive the off cell information from the flash memories 4101 to 4104 and may determine whether the block continuous-write is possible. Alternatively, the SSD controller 4200 may receive the off cell information from the flash memories 4101 to 4104 and may manage status information about the block continuous-write.

According to the present disclosure, because whether a block continuous-write is possible is determined with respect to a plurality of free pages during one busy signal period, a time taken to perform the block continuous-write operation may decrease.

One or more of the elements disclosed above may include or be implemented in one or more processing circuitries such as hardware including logic circuits; a hardware/software combination such as a processor executing software; or a combination thereof. For example, the processing circuitries more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

## Claims

1. A storage device (1000, 2000) comprising:
a first word line (WL6 - WL8) connected with memory cells (MC6 - MC8) being in a program state;
a second word line (WL1 - WL3) connected with memory cells (MC1 - MC3) being in an erase state; and
a free word line (WL5, WL4) between the first and second word lines (WL1 - WL3, WL6 - WL8) and connected with memory cells (MC1 - MC5) being in the erase state,
wherein whether a block continuous-write is possible with respect to the memory cells (MC1 - MC3) connected with the second word line (WL1 - WL3) is determined by verifying the erase state of the memory cells (MC5, MC4) connected with the free word line (WL5, WL4) during one busy signal period.

2. The storage device (1000, 2000) of claim 1, wherein a free word line check operation is performed within a flash memory (1100, 2100) to verify the erase state of the memory cells (MC5, MC4) connected with the free word line (WL5, WL4), and an operation of determining whether the block continuous-write of the memory cells (MC1 - MC3) connected with the second word line (WL1 - WL3) is possible is performed by a memory controller (1200, 2200).

3. The storage device (1000, 2000) of claim 2, wherein the flash memory (1100, 2100) is configured to provide an erase verify voltage (Vevfy) to the free word line (WL5, WL4) and is configured to verify whether the memory cells (MC5, MC4) connected with the free word line (WL5, WL4) are off cells.

4. The storage device (1000, 2000) of claim 2 or 3, wherein off cell information of the memory cells (MC5, MC4) connected with the free word line (WL5, WL4) is stored in a page buffer circuit (1130, 2130) of the flash memory (1100, 2100), and the off cell information is provided to the memory controller (1200, 2200) after the free word line check operation is completed.

5. The storage device (1000, 2000) of any one of the previous claims, wherein the free word line (WL5, WL4) includes one word line (WL5) and is connected with a plurality of pages distinguished from each other by string selection lines (SSL).

6. The storage device (1000, 2000) of claim 5, wherein all the pages connected with the free word line (WL5) are in the erase state.

7. The storage device (1000, 2000) of any one of claims 1 to 4, wherein the free word line (WL5, WL4) includes a third word line (WL5) and a fourth word line (WL4),
wherein the third word line (WL5) is connected with a plurality of pages distinguished from each other by string selection lines (SSL), and
wherein some of the plurality of pages connected with the third word line (WL5) are in the program state, and the others thereof are in the erase state.

8. The storage device (1000, 2000) of claim 7, wherein the fourth word line (WL4) is between the second (WL1 - WL3) and third word lines (WL5) and is connected with a plurality of pages distinguished from each other by the string selection lines (SSL), and
wherein the plurality of pages connected with the fourth word line (WL4) are in the erase state.

9. The storage device (1000, 2000) of claim 1, wherein a free word line check operation in which the erase state of the memory cells (MC5, MC4) connected with the free word line (WL5, WL4) is verified and an operation in which whether the block continuous-write of the memory cells (MC1 - MC3) connected with the second word line (WL1 - WL3) is possible is determined are performed within a flash memory (1100, 2100), and
wherein information about whether the block continuous-write is possible is provided to the memory controller (1200, 2200).

10. The storage device (1000, 2000) of claim 9, wherein the flash memory (1100, 2100) is configured to determine whether the block continuous-write is possible, by providing an erase verify voltage (Vevfy) to the free word line (WL5, WL4) and verifying whether the memory cells (MC5, MC4) connected with the free word line (WL5, WL4) are off cells.

11. A flash memory (1100, 2100) comprising:
a first word line (WL6 - WL8) connected with memory cells (MC6- MC8) being in a program state;
a second word line (WL1 - WL3) connected with memory cells (MC1 - MC3) being in an erase state; and
a free word line (WL5, WL4) between the first and second word lines (WL1 - WL3, WL6 - WL8) and connected with memory cells (MC5, MC4) being in the erase state,
wherein the free word line (WL5, WL4) is divided into a plurality of free pages by a plurality of string selection lines (SSL), and
wherein the plurality of string selection lines (SSL) are sequentially activated during one busy signal period such that erase states of the plurality of free pages are sequentially verified.

12. The flash memory (1100, 2100) of claim 11, wherein the flash memory (1100, 2100) is configured to provide an erase verify voltage (Vevfy) to the free word line (WL5, WL4) and provides an erase state verification result of the plurality of free pages to a memory controller (1200, 2200).

13. The flash memory (1100, 2100) of claim 12, wherein the memory controller (1200, 2200) is configured to determine whether a block continuous-write is possible, based on the erase state verification result of the plurality of free pages.

14. The flash memory (1100, 2100) of claim 13, wherein the flash memory (1100, 2100) is configured to perform the block continuous-write of the memory cells (MC1 - MC3) connected with the second word line (WL1 - WL3) based on a result of determining, at the memory controller (1200, 2200), whether the block continuous-write is possible.

15. The flash memory (1100, 2100) of claim 11, wherein the flash memory (1100, 2100) is configured to check whether the memory cells connected (MC5, MC4) with the free word line (WL5, WL4) are off cells, by providing an erase verify voltage (Vevfy) to the free word line (WL5, WL4) during the one busy signal period.
